# EUROPÄISCHE PATENTSCHRIFT

(11) **EP 3 987 296 B1**
(45) Veröffentlichungstag und Bekanntmachung des Hinweises auf die Patenterteilung: **25.06.2025**
(21) Anmeldenummer: 20746880.2
(22) Anmeldetag: 10.07.2020
(51) Int. Cl.: G01R 1/36, H01F 27/42, H01F 3/14, H01F 38/26, H02J 3/00, H02J 3/36, H02H 9/02

(54) **SCHUTZ EINES WECHSELSTROMGERÄTS**
PROTECTION OF AN AC DEVICE
PROTECTION D'UN DISPOSITIF À COURANT ALTERNATIF

(30) Priorität: 08.08.2019 DE 102019211948
(43) Veröffentlichungstag der Anmeldung: 27.04.2022
(73) Patentinhaber: HSP Hochspannungsgeräte GmbH, 53842 Troisdorf (DE)
(72) Erfinder: PRUCKER, Udo, 90571 Schwaig (DE)
(74) Vertreter: Betten & Resch
(86) Internationale Anmeldenummer: PCT/EP2020/069489
(87) Internationale Veröffentlichungsnummer: WO 2021/023472

(56) Entgegenhaltungen:
- CN-U- 205 882 640
- DE-A1- 102016 205 118
- JP-U- H01 165 613
- US-A- 2 089 860
- US-A- 3 240 957
- US-A- 3 489 975

## Beschreibung

Die Erfindung betrifft ein Energieübertragungssystem umfassend eine Schutzvorrichtung zum Schutz eines mit einer Wechselstromleitung elektrisch verbundenen Wechselstromgeräts sowie ein Verfahren in dem Energieübertragungssystem und dessen Verwendung.

Im Folgenden werden Wechselstrom und Wechselspannung führende Stromleitungen als Wechselstromleitungen, Gleichstrom und Gleichspannung führende Stromleitungen als Gleichstromleitungen bezeichnet. Gleichstromleitungen werden insbesondere zur Energieübertragung über große Entfernungen mit hohen Gleichspannungen mit der so genannten Hochspannungs-Gleichstrom-Übertragung (HGÜ) eingesetzt. Um Wechselstromleitungen und Gleichstromleitungen von Stromnetzen effizient zu verlegen, können Wechselstromleitungen und Gleichstromleitungen zumindest abschnittsweise zwischen denselben Leitungsmasten als Freileitungen aufgehängt werden und zwischen diesen Leitungsmasten dementsprechend parallel zueinander verlaufen. Insbesondere an hohen Gleichspannungen führenden Gleichstromleitungen kann Ionisation der die Gleichstromleitungen umgebenden Luft auftreten. Wenn benachbart zu einer Gleichstromleitung eine Wechselstromleitung verläuft, kann eine derartige Ionisation Ionenströme zu der Wechselstromleitung verursachen, die in der Wechselstromleitung fließende Gleichströme verursachen. Derartige Gleichströme in einer Wechselstromleitung können Stromstärken von typischerweise etwa 100 mA erreichen. Diese Gleichströme können in einem Normalbetrieb eines Wechselspannungssystems beispielsweise über einen Leistungstransformator abfließen, der mit der Wechselstromleitung verbunden ist. Wenn die Wechselstromleitung jedoch mit der Primärwicklung eines induktiven Spannungswandlers verbunden ist und frei geschaltet wurde, ohne geerdet zu sein, oder kein Leistungstransformator vorhanden ist oder der Leistungstransformator weggeschaltet ist, fließen die Gleichströme über die Primärwicklung des Spannungswandlers, wodurch der Spannungswandler in die magnetische Sättigung getrieben und dadurch thermisch überlastet und zerstört wird.

Aus der US 3 240 957 A ist eine Schutzvorrichtung für ein mit einer Wechselstromleitung elektrisch verbundenes Wechselstromgerät bekannt, die Schutzvorrichtung umfassend wenigstens eine parallel zu dem Wechselstromgerät mit der Wechselstromleitung verbundene Stromableitungsspule und für jede Stromableitungsspule einen Magnetkern mit einem ersten Magnetkernabschnitt, um den herum die Stromableitungsspule verläuft.

Aus der DE 10 2016 205 118 A1 ist ein Verfahren zur Erweiterung der elektrischen Übertragungskapazität eines Freileitungsmastsystems als Teil eines Hochspannungsnetzes bekannt, wobei das Freileitungsmastsystem als Hybridsystem für Wechselstrom und Gleichstrom ausgelegt ist.

Der Erfindung liegt die Aufgabe zugrunde, ein Energieübertragungssystem umfassend eine Schutzvorrichtung und ein Verfahren zum Schutz eines mit einer Wechselstromleitung elektrisch verbundenen Wechselstromgeräts, insbesondere eines induktiven Spannungswandlers, vor einer Schädigung durch in der Wechselstromleitung fließende Gleichströme anzugeben, insbesondere wenn eine Gleichstromleitung, beispielsweise eine HGÜ-Leitung, benachbart zu der Wechselstromleitung verläuft.

Die Aufgabe wird erfindungsgemäß durch ein Energieübertragungssystem mit den Merkmalen des Anspruchs 1, ein Verfahren in dem Energieübertragungssystem mit den Merkmalen des Anspruchs 9 und dessen Verwendung mit den Merkmalen des Anspruchs 10 gelöst.

Vorteilhafte Ausgestaltungen der Erfindung sind Gegenstand der Unteransprüche.

Ein erfindungsgemäßes Energieübertragungssystem mit einer Schutzvorrichtung für einen mit einer Wechselstromleitung elektrisch verbundenen Spannungswandler, umfasst wenigstens eine parallel zu dem Spannungswandler mit der Wechselstromleitung verbundene Stromableitungsspule und für jede Stromableitungsspule einen Magnetkern mit einem ersten Magnetkernabschnitt, um den herum die Stromableitungsspule verläuft.

Die Parallelschaltung der wenigstens einen Stromableitungsspule der Schutzvorrichtung und des zu schützenden Spannungswandlers bewirkt eine Aufteilung des Stroms auf die wenigstens einen Stromableitungsspule und den Spannungswandler.

Dadurch fließt ein geringerer Strom durch den Spannungswandler. Insbesondere werden durch den Spannungswandler fließende Gleichströme reduziert, die den Spannungswandler beschädigen oder zerstören können. Jeder Magnetkern wird vorzugsweise derart ausgelegt, dass er nicht schon bei relativ kleinen Gleichströmen in die magnetische Sättigung getrieben wird. Die Schutzvorrichtung kann insbesondere mehrere Stromableitungsspulen aufweisen, die jeweils parallel zu dem Spannungswandler geschaltet werden und um einen Magnetkernabschnitt eines Magnetkerns herum verlaufen.

Eine Ausgestaltung der Schutzvorrichtung sieht vor, dass wenigstens ein Magnetkern wenigstens einen Luftspalt aufweist. Insbesondere kann der erste Magnetkernabschnitt wenigstens eines Magnetkerns wenigstens einen Luftspalt aufweisen. Ferner kann wenigstens ein Magnetkern einen zweiten Magnetkernabschnitt aufweisen, der nicht von der Stromableitungsspule umlaufen wird und wenigstens einen Luftspalt aufweist. Die Ausführung wenigstens eines Magnetkerns mit wenigstens einem Luftspalt bewirkt vorteilhaft, dass die magnetische Sättigung des Magnetkerns erst bei wesentlichen höheren Magnetfeldstärken als bei einem sonst gleichen Magnetkern ohne einen Luftspalt eintritt. Um denselben Effekt mit einem Magnetkern ohne einen Luftspalt zu erreichen, müsste der Querschnitt des Magnetkerns wesentlich erhöht werden, was die Materialkosten und den Platzbedarf für die Messanordnung erhöhen würde. Insbesondere kann vorteilhaft vorgesehen sein, dass wenigstens ein Magnetkern wenigstens einen Luftspalt in dem von einer Stromableitungsspule umgebenen ersten Magnetkernabschnitt und wenigstens einen Luftspalt in einem zweiten Magnetkernabschnitt aufweist. Dadurch kann auf einen Luftspalt in dem zweiten Magnetkernabschnitt zugegriffen werden, um die magnetischen Eigenschaften des Magnetkerns zu optimieren.

Bei dem erfindungsgemäßen Verfahren zum Schutz eines mit einer Wechselstromleitung elektrisch verbundenen induktiven Spannungswandlers wird dementsprechend jede Stromableitungsspule einer erfindungsgemäßen Schutzvorrichtung parallel zu dem Spannungswandler mit der Wechselstromleitung elektrisch verbunden.

Ein erfindungsgemäßes Energieübertragungssystem mit einer Messanordnung zum Messen einer Wechselspannung an einer Wechselstromleitung umfasst einen induktiven Spannungswandler mit einer Primärwicklung mit einem ersten Primärwicklungsende, das mit der Wechselstromleitung elektrisch verbunden ist, und wenigstens eine erfindungsgemäße Schutzvorrichtung, wobei jede Stromableitungsspule der Schutzvorrichtung parallel zu der Primärwicklung des Spannungswandlers geschaltet ist und die Schutzvorrichtung einen geringeren elektrischen Wirkwiderstand als die Primärwicklung des Spannungswandlers aufweist. Beispielsweise ist der Wirkwiderstand der Schutzvorrichtung höchstens halb so groß wie der Wirkwiderstand der Primärwicklung des Spannungswandlers. Dadurch, dass die Schutzvorrichtung einen geringeren Wirkwiderstand als die Primärwicklung des Spannungswandlers hat, fließt der größte Teil des Stroms durch die Schutzvorrichtung, und die Primärwicklung des Spannungswandlers wird besonders gut gegen eine Schädigung durch Gleichströme geschützt.

Eine Ausgestaltung der Messanordnung sieht vor, dass ein zweites Primärwicklungsende der Primärwicklung des Spannungswandlers auf ein Erdpotential gelegt ist. Dadurch wird das zweite Primärwicklungsende auf ein definiertes Bezugspotential gelegt.

Ein erfindungsgemäßes Energieübertragungssystem umfasst eine Gleichstromleitung, eine Wechselstromleitung, die benachbart zu der Gleichstromleitung verläuft, und eine erfindungsgemäße Messanordnung, deren erstes Primärwicklungsende mit der Wechselstromleitung elektrisch verbunden ist. Beispielsweise sind die Gleichstromleitung und die Wechselstromleitung Freileitungen und/oder sie sind zumindest abschnittsweise zwischen denselben Leitungsmasten aufgehängt.

Ein derartiges Energieübertragungssystem ermöglicht insbesondere eine Hochspannungs-Gleichstrom-Übertragung über die Gleichstromleitung ohne die oben erwähnte Gefährdung des mit der Wechselstromleitung verbundenen Spannungswandlers durch von der Gleichstromleitung verursachte Ionenströme, da Gleichströme, die sonst über den Spannungswandler fließen würden, im Wesentlichen über die Stromableitungsspule der Messanordnung fließen und den Spannungswandler nicht in die magnetische Sättigung treiben.

Dementsprechend sieht die Erfindung insbesondere die Verwendung eines erfindungsgemäßen Energieübertragungssystems zu einer Hochspannungs-Gleichstrom-Übertragung über die Gleichstromleitung vor.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: ein Blockdiagramm eines Ausführungsbeispiels eines Energieübertragungssystems,
- FIG 2: eine aufgebrochene perspektivische Darstellung eines Ausführungsbeispiels einer Schutzvorrichtung.

Einander entsprechende Teile sind in den Figuren mit denselben Bezugszeichen versehen.

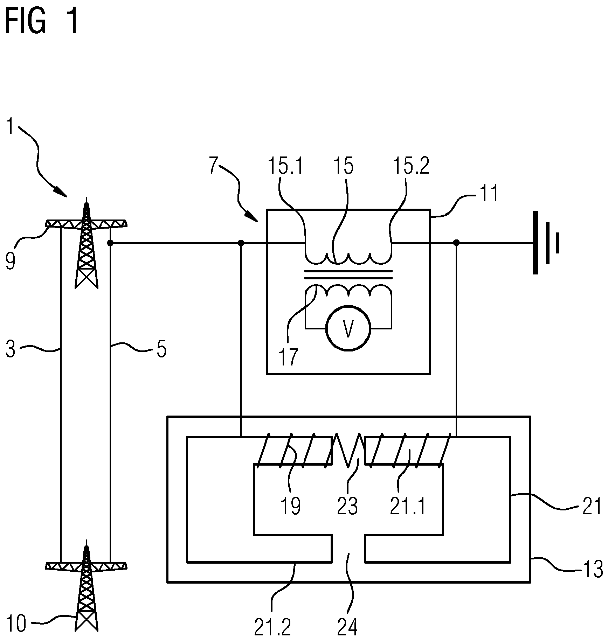

Figur 1 (FIG 1) zeigt ein Blockdiagramm eines Ausführungsbeispiels eines erfindungsgemäßen Energieübertragungssystems 1. Das Energieübertragungssystem 1 umfasst eine Gleichstromleitung 3, eine Wechselstromleitung 5 und ein Ausführungsbeispiel einer erfindungsgemäßen Messanordnung 7 zum Messen einer Wechselspannung an der Wechselstromleitung 5.

Die Gleichstromleitung 3 und die Wechselstromleitung 5 sind zumindest abschnittsweise zwischen denselben Leitungsmasten 9, 10 aufgehängt. In Figur 1 sind exemplarisch nur je ein Abschnitt der Gleichstromleitung 3 und der Wechselstromleitung 5 dargestellt, wobei diese Abschnitte parallel und benachbart zueinander als Freileitungen zwischen zwei Leitungsmasten 9, 10 verlaufen. Die Gleichstromleitung 3 ist beispielsweise eine HGÜ-Leitung, die Wechselstromleitung 5 ist eine Leitung eines Wechselstromnetzes.

Die Messanordnung 7 umfasst einen induktiven Spannungswandler 11 und eine erfindungsgemäße Schutzvorrichtung 13. Der Spannungswandler 11 weist eine Primärwicklung 15 und eine Sekundärwicklung 17 auf. Ein erstes Primärwicklungsende 15.1 der Primärwicklung 15 ist elektrisch mit der Wechselstromleitung 5 verbunden. Ein zweites Primärwicklungsende 15.2 der Primärwicklung 15 ist auf ein Erdpotential gelegt. An der Sekundärwicklung 17 wird eine Sekundärspannung abgegriffen, aus der die an der Wechselstromleitung 5 gegenüber dem Erdpotential anliegende Wechselspannung ermittelt wird.

Die Schutzvorrichtung 13 umfasst eine Stromableitungsspule 19 und einen Magnetkern 21. Die Stromableitungsspule 19 ist parallel zu der Primärwicklung 15 des Spannungswandlers 11 geschaltet und weist einen wesentlich geringeren elektrischen Wirkwiderstand als die Primärwicklung 15 auf. Beispielsweise ist der Wirkwiderstand der Primärwicklung 15 mindestens zehnmal so groß wie der Wirkwiderstand der Stromableitungsspule 19.

Die Stromableitungsspule 19 verläuft um einen ersten Magnetkernabschnitt 21.1 des Magnetkerns 21 herum, der einen Luftspalt 23 aufweist. In einem zweiten Magnetkernabschnitt 21.2, der nicht von der Stromableitungsspule 19 umlaufen wird, weist der Magnetkern 21 einen weiteren Luftspalt 24 auf. Die Luftspalte 23, 24 sind beispielsweise jeweils mit Hartpapier oder einem Pressspan ausgefüllt (nicht dargestellt). Andere Ausführungsbeispiele der Schutzvorrichtung 13 können insbesondere einen Magnetkern 21 mit mehr als nur zwei Luftspalten 23, 24 aufweisen.

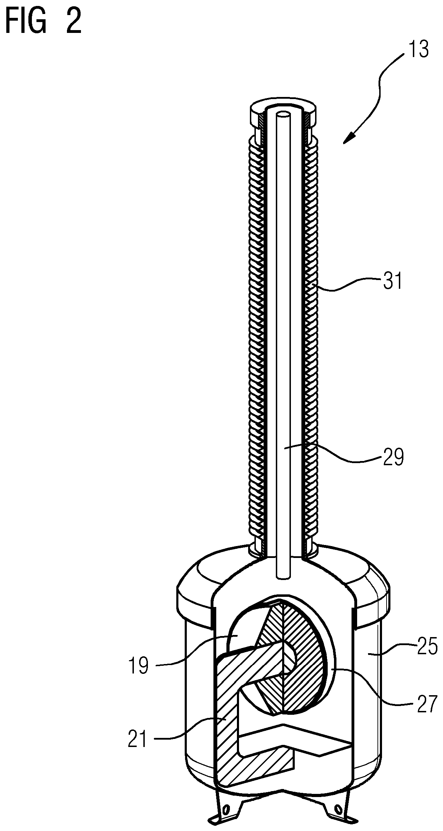

Figur 2 (FIG 2) zeigt eine aufgebrochene perspektivische Darstellung eines Ausführungsbeispiels einer Schutzvorrichtung 13. Die Stromableitungsspule 19 und der Magnetkern 21 sind in einem Gehäuse 25 angeordnet. Um die Stromableitungsspule 19 herum ist eine Abschirmelektrode 27 zum Abschirmen elektrischer Felder gegen das Gehäuse 25 angeordnet. Aus dem Gehäuse 25 ist ein elektrischer Leiter 29 herausgeführt, der außerhalb des Gehäuses 25 von einem Hohlisolator 31 umgeben ist und über den die Stromableitungsspule 19 von außen kontaktierbar ist.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung gemäß der Ansprüche zu verlassen.

## Patentansprüche

1. Energieübertragungssystem (1), umfassend
- eine Gleichstromleitung (3),
- eine Wechselstromleitung (5), die benachbart zu der Gleichstromleitung (3) verläuft, und
- eine Messanordnung (7) zum Messen einer Wechselspannung an der Wechselstromleitung (5), die Messanordnung (7) umfassend
- einen induktiven Spannungswandler (11) mit einer Primärwicklung (15) mit einem ersten Primärwicklungsende (15.1), das mit der Wechselstromleitung (5) elektrisch verbunden ist, und
- wenigstens eine Schutzvorrichtung (13) die Schutzvorrichtung (13) umfassend
- wenigstens eine parallel zu dem induktiven Spannungswandler (11) mit der Wechselstromleitung (5) verbundene Stromableitungsspule (19) und
- für jede Stromableitungsspule (19) einen Magnetkern (21) mit einem ersten Magnetkernabschnitt (21.1), um den herum die Stromableitungsspule (19) verläuft, wobei
- jede Stromableitungsspule (19) der Schutzvorrichtung (13) parallel zu der Primärwicklung (15) des Spannungswandlers (11) geschaltet ist und
- die Schutzvorrichtung (13) einen geringeren elektrischen Wirkwiderstand als die Primärwicklung (15) des Spannungswandlers (11) aufweist.

2. Energieübertragungssystem (1) nach Anspruch 1, wobei die Gleichstromleitung (3) und die Wechselstromleitung (5) zumindest abschnittsweise zwischen denselben Leitungsmasten (9, 10) aufgehängt sind.

3. Energieübertragungssystem (1) nach einem der vorhergehenden Ansprüche, wobei die Gleichstromleitung (3) und die Wechselstromleitung (5) Freileitungen sind.

4. Energieübertragungssystem (1) nach einem der vorhergehenden Ansprüche, wobei die Schutzvorrichtung (13) wenigstens einen Magnetkern (21) umfasst, der wenigstens einen Luftspalt (23, 24) aufweist.

5. Energieübertragungssystem (1) nach einem der vorhergehenden Ansprüche, wobei die Schutzvorrichtung (13) wenigstens einen Magnetkern (21) umfasst, dessen erster Magnetkernabschnitt (21.1) wenigstens einen Luftspalt (23) aufweist.

6. Energieübertragungssystem (1) nach einem der vorhergehenden Ansprüche, wobei die Schutzvorrichtung (13) wenigstens einen Magnetkern (21) umfasst, der einen zweiten Magnetkernabschnitt (21.2) aufweist, der nicht von der Stromableitungsspule (19) umlaufen wird und wenigstens einen Luftspalt (24) aufweist.

7. Energieübertragungssystem (1) nach einem der vorhergehenden Ansprüche, wobei der Wirkwiderstand der Primärwicklung (15) des Spannungswandlers (11) mindestens doppelt so groß wie der Wirkwiderstand der Schutzvorrichtung (13) ist.

8. Energieübertragungssystem (1) nach einem der vorhergehenden Ansprüche, wobei ein zweites Primärwicklungsende (15.2) der Primärwicklung (15) des Spannungswandlers (11) auf ein Erdpotential gelegt ist.

9. Verfahren zur Durchführung in einem Energieübertragungssystem (1) nach einem der vorhergehenden Ansprüche zum Schutz eines mit einer Wechselstromleitung (5) elektrisch verbundenen induktiven Spannungswandlers (11) vor einer Schädigung durch in der Wechselstromleitung (5) fließende Gleichströme, wobei jede Stromableitungsspule (19) der Schutzvorrichtung (13) parallel zu dem Spannungswandler (11) mit der Wechselstromleitung (5) elektrisch verbunden wird.

10. Verwendung eines Energieübertragungssystems (1) nach einem der Ansprüche 1 bis 8 zu einer Hochspannungs-Gleichstrom-Übertragung über die Gleichstromleitung (3).

## Claims

1. A power transmission system (1), comprising
- a DC line (3),
- an AC line (5) running adjacent to the DC line (3), and
- a measuring arrangement (7) for measuring an AC voltage on the AC line (5), the measuring arrangement (7) comprising
- an inductive voltage transformer (11) having a primary winding (15) having a first primary winding end (15.1), which is electrically connected to the AC line (5), and
- at least one protection device (13), the protection device (13) comprising
- at least one current drain coil (19) connected to the AC line (5) in parallel with the inductive voltage transformer (11), and
- for each current drain coil (19) a magnetic core (21) having a first magnetic core section (21.1), around which the current drain coil (19) runs, wherein
- each current drain coil (19) of the protection device (13) is connected in parallel with the primary winding (15) of the voltage transformer (11), and
- the protection device (13) has a lower effective electrical resistance than the primary winding (15) of the voltage transformer (11).

2. The power transmission system (1) as claimed in claim 1, wherein the DC line (3) and the AC line (5) are suspended between the same line masts (9, 10) at least in sections.

3. The power transmission system (1) as claimed in any of the previous claims, wherein the DC line (3) and the AC line (5) are overhead lines.

4. The power transmission system (1) as claimed in any of the previous claims, wherein the protection device (13) comprises at least one magnetic core (21) that has at least one air gap (23, 24).

5. The power transmission system (1) as claimed in any of the previous claims, wherein the protection device (13) comprises at least one magnetic core (21), of which a first magnetic core section (21.1) has at least one air gap (23).

6. The power transmission system (1) as claimed in any of the previous claims, wherein the protection device (13) comprises at least one magnetic core (21), which has a second magnetic core section (21.2), around which the current drain coil (19) does not run and which has at least one air gap (24).

7. The power transmission system (1) as claimed in any of the previous claims, wherein the effective resistance of the primary winding (15) of the voltage transformer (11) has a magnitude at least double that of the effective resistance of the protection device (13).

8. The power transmission system (1) as claimed in any of the previous claims, wherein a second primary winding end (15.2) of the primary winding (15) of the voltage transformer (11) is connected to a ground potential.

9. A method for being carried out in an energy transmission system (1) according to one of the preceding claims for protecting an inductive voltage transformer (11) electrically connected to an AC line (5) against damage as a result of DC currents flowing in the AC line (5), wherein each current drain coil (19) of the protection device (13) is electrically connected to the AC line (5) in parallel with the voltage transformer (11).

10. The use of a power transmission system (1) as claimed in any of claims 1 to 8 for a high-voltage direct current transmission via the DC line (3).

## Revendications

1. Système (1) de transmission d'énergie, comprenant :
- une ligne (3) de courant continu,
- une ligne (5) de courant alternatif qui s'étend à proximité de la ligne (3) de courant continu, et
- un dispositif de mesure (7) pour mesurer une tension alternative sur la ligne (5) de courant alternatif, le dispositif de mesure (7) comprenant
- un transformateur de tension inductif (11) comprenant un enroulement primaire (15) dont une première extrémité d'enroulement primaire (15.1) est reliée électriquement à la ligne (5) de courant alternatif, et
- au moins un dispositif de protection (13) comprenant
- au moins une bobine (19) de dérivation de courant reliée en parallèle au transformateur de tension inductif (11) avec la ligne (5) de courant alternatif, et,
- pour chaque bobine (19) de dérivation de courant, un noyau magnétique (21) comprenant une première partie (21.1) de noyau magnétique, autour de laquelle s'étend la bobine (19) de dérivation de courant,
- chaque bobine (19) de dérivation de courant du dispositif de protection (13) étant connectée en parallèle avec l'enroulement primaire (15) du transformateur de tension (11) et
- le dispositif de protection (13) présente une résistance électrique effective inférieure à celle de l'enroulement primaire (15) du transformateur de tension (11).

2. Système (1) de transmission d'énergie selon la revendication 1, dans lequel la ligne (3) de courant continu et la ligne (5) de courant alternatif sont suspendues, au moins partiellement, entre les mêmes pylônes (9, 10).

3. Système (1) de transmission d'énergie selon l'une des revendications précédentes, dans lequel la ligne (3) de courant continu et la ligne (5) de courant alternatif sont des lignes aériennes.

4. Système (1) de transmission d'énergie selon l'une des revendications précédentes, dans lequel le dispositif de protection (13) comprend au moins un noyau magnétique (21) qui présente au moins un entrefer (23, 24).

5. Système (1) de transmission d'énergie selon l'une des revendications précédentes, dans lequel le dispositif de protection (13) comprend au moins un noyau magnétique (21) dont la première partie (21.1) de noyau magnétique présente au moins un entrefer (23).

6. Système (1) de transmission d'énergie selon l'une des revendications précédentes, dans lequel le dispositif de protection (13) comprend au moins un noyau magnétique (21) qui présente une deuxième partie (21.2) de noyau magnétique qui n'est pas entourée par la bobine (19) de dérivation de courant et qui présente au moins un entrefer (24).

7. Système (1) de transmission d'énergie selon l'une des revendications précédentes, dans lequel la résistance effective de l'enroulement primaire (15) du transformateur de tension (11) est au moins deux fois plus grande que la résistance effective du dispositif de protection (13).

8. Système (1) de transmission d'énergie selon l'une des revendications précédentes, dans lequel une deuxième extrémité (15.2) de l'enroulement primaire (15) du transformateur de tension (11) est mise à la terre.

9. Procédé destiné à être mis en œuvre dans un système de transmission d'énergie selon l'une des revendications précédentes pour protéger un transformateur de tension inductif (11) relié électriquement à une ligne (5) de courant alternatif contre les dommages causés par les courants continus circulant dans la ligne (5) de courant alternatif, chaque bobine (19) de dérivation de courant du dispositif de protection (13) étant reliée électriquement à la ligne (5) de courant alternatif en parallèle avec le transformateur de tension (11).

10. Utilisation d'un système (1) de transmission d'énergie selon l'une des revendications 1 à 8 pour une transmission de courant continu haute tension via la ligne (3) de courant continu.
